Europäisches Patentamt

European Patent Office

Office européen des brevets

(11) Veröffentlichungsnummer : **0 141 963**
**B1**

(12) # EUROPÄISCHE PATENTSCHRIFT

(45) Veröffentlichungstag der Patentschrift :
11.11.87

(51) Int. Cl.⁴ : **G 12 B 11/04, G 01 D 11/28**

(21) Anmeldenummer : **84110838.4**

(22) Anmeldetag : **12.09.84**

(54) **Anordnung zur Beleuchtung eines Zeigers mittels Durchlicht.**

(30) Priorität : **21.09.83 DE 3334041**

(43) Veröffentlichungstag der Anmeldung :
**22.05.85 Patentblatt 85/21**

(45) Bekanntmachung des Hinweises auf die Patenterteilung : **11.11.87 Patentblatt 87/46**

(84) Benannte Vertragsstaaten :
**DE FR GB IT**

(56) Entgegenhaltungen :
**GB-A- 902 260**
**US-A- 3 005 439**

(73) Patentinhaber : **Mannesmann Kienzle GmbH**
**Heinrich-Hertz-Strasse**
**D-7730 Villingen-Schwenningen (DE)**

(72) Erfinder : **Maier, Wolfgang**
**Kopsbühl 80**
**D-7730 Villingen-Schwenningen (DE)**
Erfinder : **Modest, Otmar**
**Ifflingerstrasse 18**
**D-7732 Niedereschach (DE)**
Erfinder : **Preuss, Helmut**
**Oderstrasse 72**
**D-7730 Villingen-Schwenningen (DE)**

Jouve, 18, rue St-Denis, 75001 Paris, France

**Beschreibung**

Die Erfindung betrifft eine Anordnung zur Beleuchtung eines Zeigers mittels Durchlicht mit wenigstens einer im Innern des betreffenden Meßgerätes angeordneten Lichtquelle und einem der Lichtquelle zugeordneten, plattenförmigen Lichtleitkörper, welcher in Zuordnung zur Zeigernabe derart ausgebildet ist, daß in den Lichtleitkörper eingespeistes Licht an einer zur Zeigerwelle konzentrischen Fläche aus dem Lichtleitkörper austritt.

Es ist bekannt, daß die Durchlichtbeleuchtung von Skalen und Zeigern analog anzeigender Meßgeräte im Gegensatz zur Auflichtbeleuchtung eine gleichmäßige sowie blend- und lichthoffreie Ausleuchtung der Anzeigemittel bietet. Auch in ungünstigen Fällen, beispielsweise bei großen Gerätequerschnitten und kompakter Bauweise, läßt sich die Durchleuchtung der Skalen, d. h. die Verteilung des Lichtes einer oder mehrerer, im Innern des Meßgerätes angeordneter Lichtquellen auf einfache Weise mittels eines im Skalenbereich großflächig Licht abstrahlenden Lichtleitkörpers verwirklichen. Problematisch ist demgegenüber die Durchleuchtung des oder der den Skalen zugeordneten Zeiger, insbesondere wenn diese die Skalen übergreifen und wenn mehrere Zeiger konzentrisch angeordnet sind und somit das der Zeigerbeleuchtung dienende Licht über die Zeigernaben in die entsprechend lichtleitend ausgebildeten Zeiger eingeflutet werden muß, also sog. Scheibenzeiger und dergl. nicht in Frage kommen. Eine möglichst gleichmäßige Ausleuchtung einer Zeigerfahne erfordert in diesem Falle eine relativ hohe Lichtdichte an der an der Zeigernabe ausgebildeten Übernahmefläche, was bedeutet, daß das der Zeigerbleuchtung dienende Licht an einer dem Zeigerausschlag entsprechenden und der Übernahmefläche zugeordneten, vorzugsweise kreisbogenförmigen, im Falle eine umlaufenden Uhrzeigers ringförmigen Zone des Lichtleitkörpers mit möglichst hoher Intensität abgestrahlt wird.

Eine in diesem Sinne vorteilhafte Anordnung zeigt die GB-A-902 260. Bei dem betreffenden Meßgerät ist die Zeigerwelle durch einen umlaufenden Arm, an dem der Zeiger exzentrisch befestigt ist, ersetzt. In dem auf diese Weise freien Raum der geometrischen Zeigerachse ist ein Lichtleiter angeordnet, an dessen dem Zeiger zugewandten einen Ende eine Sammellinse und an dessen anderem Ende der oder den Lichtquellen zugeordnete Prismenflächen zur Einleitung von Licht in den Lichtleiter ausgebildet sind. Diese Lösung optimiert zwar die Lichtleitung für die Zeigerbeleuchtung, sie erfordert jedoch relativ viel Raum in Richtung der Meßgeräteachse und eine aufwendige und baulich in den wenigsten Fällen realisierbare Zeigerbefestigung, die in geeigneter Weise durch eine großflächige Blende nach außen abgedeckt werden muß.

Außerdem wird das Beleuchtungsproblem durch geschmackliche Forderungen, die, was natürlich auch wegen der Parallaxe vorteilhaft ist, geringe Bauhöhe und feine Zeigerfahne mit möglichst kleinem Zeigerauge vorsehen, verschärft, d. h. daß im wesentlichen nur Zeigernaben mit relativ kleinen Durchmessern, an denen lediglich kleine Lichtübernahmeflächen ausbildbar sind, verwirklicht werden können. Erschwerend kommt hinzu, daß die als Lichtquellen dienenden Lampen im allgemeinen nicht in der Nähe der Zeigernabe angeordnet werden können und bei Geräten mit hoher Packungsdichte der Wärmeentwicklung wegen möglichst wenig elektrische Leistung aufnehmen sollen.

Eine Lösung, die, was den Fertigungsaufwand und den Raumbedarf anbelangt, weitgehend optimiert ist, sieht beispielsweise einen im wesentlichen dem Öffnungsquerschnitt des Meßgerätes entsprechenden, scheibenförmigen und im Skalenbereich lichtstreuenden Lichtleitkörper vor, in welchen eine oder, abhängig von der Größe des Meßgerätes und der gewünschten Ausleuchtqualität mehrere Lampen eingreifen und welchem ein aus einem lichtstreuenden Werkstoff hergestelltes Skalen- und Ziffernblatt zugeordnet ist. Eine in dem Lichtleitkörper vorgesehene, konisch aufgesenkte Öffnung dient der Durchführung der Zeigerwelle aus dem Innern des Meßgerätes zu dessen Skalen- bzw. Frontseite und der Umlenkung des im Lichtleitkörper streuenden Lichtes in Richtung Zeigernabe. Aus dieser der Beleuchtung der Zeigerfahne dienenden, an einer ringförmigen Fläche aus dem Lichtleitkörper austretenden Lichtmenge wird in jeder Stellung des Zeigers über die an der Zeigernabe angeformte und der Zeigerfahne zugeordnete Übernahmefläche nur eine relativ kleine Teillichtmenge in die Zeigerfahne umgelenkt.

Dieses allgemein übliche bauliche Konzept für die Durchlichtbeleuchtung von Zeigern weist bezüglich der Lichtleitung einen ungewöhnlich schlechten Wirkungsgrad auf, und zwar abgesehen von den geschilderten, erheblich einengenden Forderungen bezüglich Bauraum und Lampenleistung deshalb, weil ausschließlich radial bzw. in einer radialen Ebene auf die konische Öffnungswand auftreffendes Licht im wesentlichen parallel zur Zeigerwelle, wenigstens jedoch innerhalb der betreffenden radialen Ebene, aus dem Lichtleitkörper abgestrahlt wird und somit für die Zeigerbeleuchtung einigermaßen nutzbar ist. Bereits bei geringen Abweichungen von dieser Auftreffrichtung wird das Licht nicht mehr in die gewünschte Richtung in etwa parallel zur Zeigerwelle, wenigstens jedoch innerhalb einer Ebene parallel zur Zeigerwelle, abgelenkt, sondern in einer zur Zeigerwelle entsprechend dem Auftreffwinkel mehr oder weniger verschwenkten Ebene.

Diese Erkenntnis zeigt, daß bei der bisher innerhalb des Lichtleitkörpers als Umlenkfläche vorgesehenen, konischen Senkung eine möglichst starke Streuung des in den Lichtleitkörper eingespeisten Lichtes angestrebt werden muß, um die Wahrscheinlichkeit des Lichtaustritts an der gewünschten ringförmigen Fläche zu erhöhen. Verständlicherweise hat diese Methode erhebliche Lichtverluste zur Folge, so daß im allgemeinen nur eine matt leuchtende Ringfläche für die Lichtübergabe in den Zeiger zur Verfügung steht. Andererseits sind infolge der baulichen und geschmacklichen Forderungen, aber auch aus fertigungstechnischen Gründen Maßnahmen zur Lichtübernahme und Lichtleitung im Zeiger selbst enge Grenzen gesetzt und Zeigerausbildungen mit lichtsammelnder Wirkung sowie bezüglich der Lichtstreuung optimal gestaltete Zeigerfahnen praktisch erschöpft, so daß die gestellte Aufgabe darin bestand, bei dem gegebenen baulichen Konzept die für die Zeigerbeleuchtung vom Lichtleitkörper abgestrahlte Lichtmenge zu steigern, ohne hierfür zusätzlichen Fertigungsaufwand in Kauf nehmen zu müssen.

Die Lösung dieser Aufgabe sieht vor, daß an dem Lichtleitkörper wenigstens eine Schar im wesentlichen ebener, lichtbrechender Flächen ausgeformt ist, und zwar derart, daß einerseits die Brechungsflächen bezüglich einer Ebene, in der sowohl die Lichtquelle als auch die geometrische Achse der Zeigerwelle liegen, senkrecht stehen, andererseits bezüglich der Zeigerwelle geneigt und zueinander derart gestaffelt sind, daß die Projektion der Brechungsflächenschar in Richtung der Zeigerwelle eine im wesentlichen kreisbogenförmige Lichtaustrittsfläche ergibt.

Der entscheidende Vorteil, den die Erfindung bietet, ist, abgesehen davon, daß er ohne zusätzlichen technischen Aufwand erzielbar ist, darin zu sehen, daß von einer Lichtquelle ausgesandtes und unmittelbar in den Bereich der Zeigerwellendurchführung gestrahltes Licht nicht, wie dies bei der bisher üblichen Lösung mit einer in Richtung der Lichtquelle gewölbten, konischen Fläche der Fall ist, weitgehend zerstreut wird, sondern mit relativ geringen Verlusten in die gewünschte Richtung lenkbar ist. D. h. daß Maßnahmen und Ausbildungen im Lichtleitkörper, die eine Konzentration oder ein Parallelrichten des Lichtes in Richtung der im Lichtleitkörper befindlichen Öffnung zur Durchführung der Zeigerwelle bewirken, beispielsweise eine Lichtkanalisierung durch parallele Schlitze, erst durch die Erfindung in vollem Umfange wirksam werden können. Infolge der höheren Lichtausbeute ist es andererseits aber auch möglich, bei sonst gleichen Verhältnissen einen dünneren Lichtleiter oder gegebenenfalls nur eine Lichtquelle bzw. Lichtquellen mit geringerer Leistungsaufnahme zu verwenden.

Andererseits lassen sich dank der Erfindung Zeigeranordnungen, wie sie beispielsweise bei Fahrtschreibern üblich sind, nämlich die zentralen Anordnungen von Geschwindigkeits-, Drehzahl- und Uhrzeitzeigern bei entsprechender Breite der lichtabstrahlenden Ringfläche befriedigend ausleuchten. Je nach Lage zweier Lampen in bezug zur Zeigerwellendurchführung durch den Lichtleiter ist es, insbesondere wenn umlaufende Zeiger ausgeleuchtet werden sollen, unter Umständen erforderlich, eine zusätzliche dritte Lampe oder eine im Lichtleiter ausgebildete, spiegelnde Fläche vorzusehen und dementsprechend drei Brechungsflächenschare auszubilden.

Die Erfindung ist aber auch in solchen Fällen anwendbar, bei denen die Zeigerwelle nicht durch einen plattenförmigen Lichtleiter hindurchgreift sondern, insbesondere wenn der Zeigerausschlag des betreffenden Meßgerätes ≤ 180° beträgt, lediglich ein stabförmiger, gegebenenfalls auch nachträglich einbaufähiger Lichtleitkörper zwischen der Lichtquelle und der Zeigerwelle vorgesehen wird.

Im folgenden sei ein Ausführungsbeispiel der Erfindung anhand der beigefügten Zeichnungen näher erläutert. Es zeigen

Fig. 1 eine Draufsicht auf die Frontseite eines teilweise aufgebrochenen Meßgerätes,

Fig. 2 einen Teilschnitt durch die Anzeige- und Beleuchtungsmittel des Meßgerätes,

Fig. 3 eine Untersicht eines im Bereich der Zeigerwellendurchführung gemäß der Erfindung gestalteten Lichtleitkörpers mit in diese Abbildung hinein projizierten Konturen der Zeigernabe,

Fig. 4 ein Schnittbild des Lichtleitkörpers gemäß der Schnittlinie A-B in Fig. 3,

Fig. 5 ein weiteres Ausführungsbeispiel eines Lichtleitkörpers, das die erfindungsgemäße Lichtführung zur Zeigerbeleuchtung mittels einer Lampe gestattet.

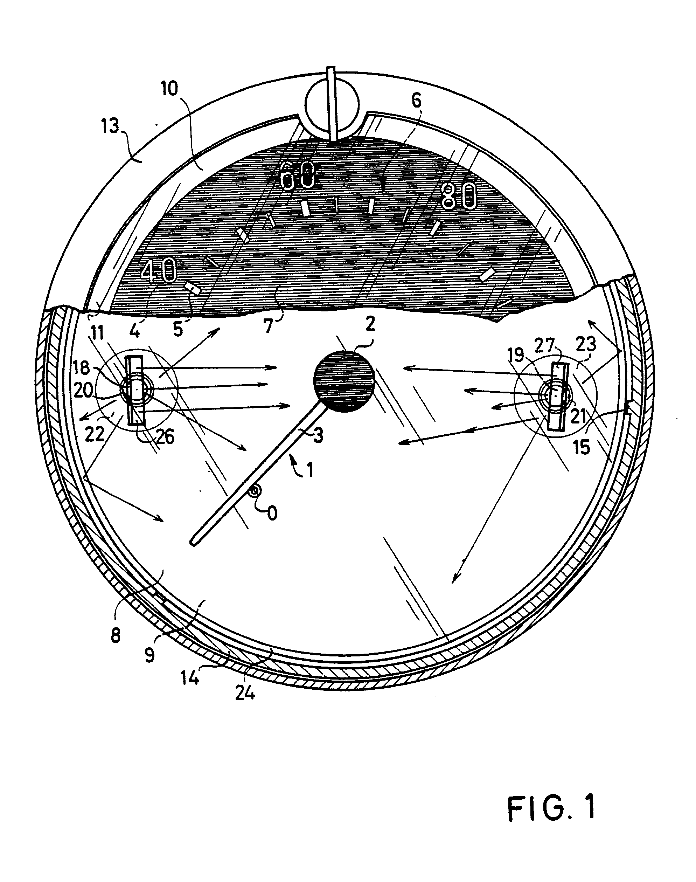

Die in Fig. 1 dargestellte Frontansicht eines teilweise aufgebrochenen Meßgerätes, beispielsweise eines als Ausführungsbeispiel gewählten Fahrtschreibers, zeigt einen im nichtmessenden Zustand an einem Anschlag 0 anliegenden, zentral angeordneten Zeiger 1, dessen lichtleitende Nabe durch eine Kappe 2 lichtundurchlässig abgedeckt ist und dessen schmale, im Durchlicht leuchtende Zeigerfahne 3 während des Messens über ebenfalls im Durchlicht leuchtende Zeiger 4 und Skalenstriche 5 einer Skala 6 spielt. Als Skalenträger bzw. als Zifferblatt 7 dient eine für derartige Zwecke entwickelte, lichtstreuende Folie, welche zur Steigerung des Kontrastes zunächst weiß gefärbt und dann unter Ausblendung der Skala 6 dunkel abgedeckt worden ist.

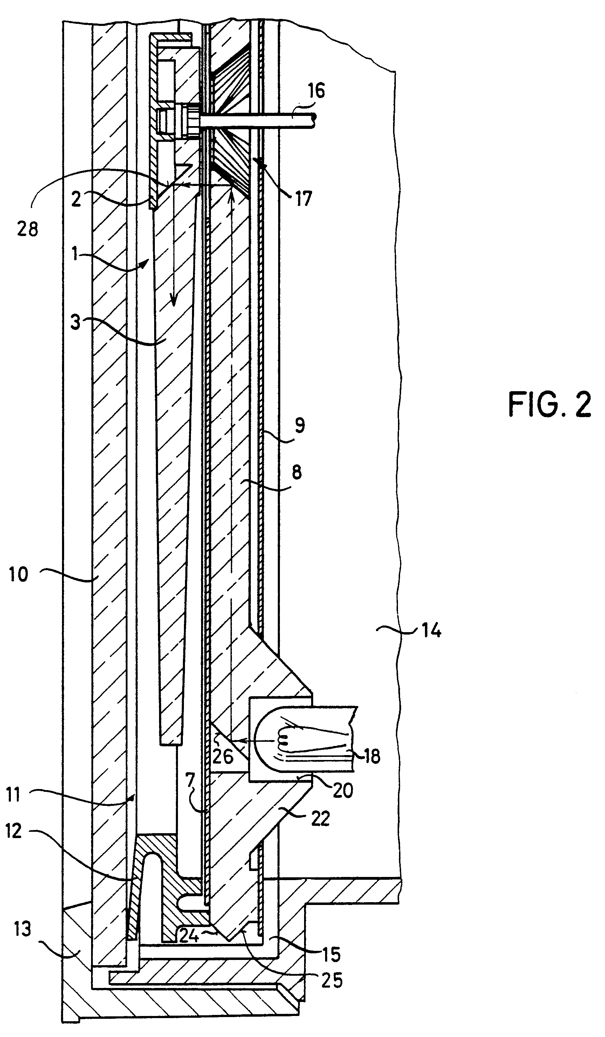

Der Skalenträger 7 liegt, was im einzelnen besser der Fig. 2 entnommen werden kann, unmittelbar auf einem scheibenförmigen, im wesentlichen dem Öffnungsquerschnitt des Meßgerätes entsprechenden Lichtleitkörper 8 auf. Dieser ist, um einen Lichtaustritt im Bereich der Ziffern 4 und der Skalenstriche 5 zu ermöglichen, einseitig aufgerauht. Ein auf der Gegenseite vorgesehener Reflektor 9 vermeidet Lichtverluste durch planseitig austretendes Licht und gleicht Helligkeitsunterschiede durch einerseits nahe an den Lichtleitkörper 8 heranreichende Bauelemente, andererseits Hohlräume, aus.

Ein zwischen dem Lichtleitkörper 8 und einer Frontscheibe 10 des Meßgerätes angeordneter Ring 11 dient sowohl als Blende als auch mit einer an ihm ausgebildeten Lippe 12 als Spielausgleichsfeder. Die Lippe 12 bewirkt, daß, wenn ein das Meßgerät frontseitig abschließender Frontring 13 mit dem Gehäuse 14 des Meßgerätes in geeigneter, nicht dargestellter Weise verrastet ist, die Frontscheibe 10 an dem Frontring 13 anliegt und der Lichtleitkörper 8 zusammen mit dem Ziffernblatt 7 und dem Reflektor 9 gegen am Gehäuse 14 ausgeformte Konsolen, von denen eine mit 15 bezeichnet ist, gehalten wird.

Wie die Fig. 2 außerdem zeigt, dienen der Durchführung einer den Zeiger 1 tragenden Zeigerwelle 16 eine im Lichtleitkörper 8 angebrachte Öffnung 17 sowie nicht näher bezeichnete Öffnungen im Skalenträger 7 und im Reflektor 9. Die Beleuchtung des Zeigers 1 und der Skala 6 erfolgt bei dem gewählten Ausführungsbeispiel mittels zweier Lampen 18 und 19, die, was nicht dargestellt ist, beispielsweise an einer gehäusefesten Wand gehaltert sind und in jeweils eine im Lichtleitkörper 8 ausgebildete Öffnung 20 bzw. 21 hineinragen. Am Lichtleitkörper 8 angeformte, konische Ansätze 22 und 23 sowie am Außenrand des Lichtleitkörpers 8 vorgesehene Facettenflächen 24 und 25 verbessern die Lichtausbeute und dienen einer möglichst gleichmäßigen Lichtverteilung im Lichtleitkörper 8, während durch nicht näher bezeichnete Einsenkungen im Lichtleitkörper 8 ausgeformte Flächen 26 und 27, die beispielsweise auch gewölbt ausgebildet sein können, eine gewisse Konzentration bzw. ein Parallelrichten von Licht in Richtung der Öffnung 17 erfolgt.

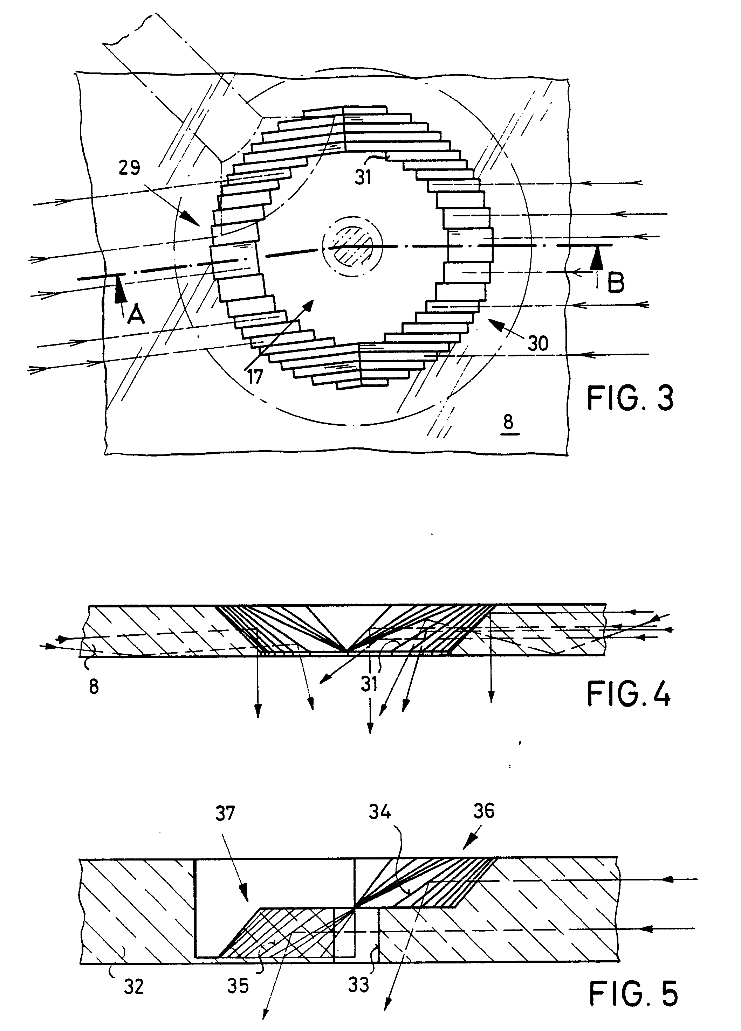

Der Umlenkung — durch Totalreflexion innerhalb des Lichtleitkörpers 8 — des von den Lappen 18 und 19 ausgestrahlten Lichtes in Richtung der Nabe des Zeigers 1, an der eine vorzugsweise konische Übernahmefläche 28 ausgebildet ist, dienen erfindungsgemäß jeweils eine jeder Lampe 18 bzw. 19 zugeordnete und gegen die jeweilige Lampe 18 bzw. 19 gerichtete Schar 29 und 30 von im Lichtleitkörper 8 ausgeformten, die Öffnung 17 begrenzenden Brechungsflächen, von denen in Fig. 3 eine mit 31 bezeichnet ist. Die Ausbildung der Brechungsflächen im Lichtleitkörper 8 ist dabei derart getroffen, daß sie zur Zeigerwelle 16 geneigt sind, bzgl. gedachter Zeigerwellen 16 und jeweils die Lampen 18 und 19 verbindenden Flächennormalen des Lichtleitkörpers 8 senkrecht stehen und zueinander derart gestaffelt sind, daß ihre Projektion in Richtung der Zeigerwelle 16 eine im wesentlichen kreisbogenförmige Lichtaustrittsfläche ergibt, mit anderen Worten, die von der Übernahmefläche 28 des Zeigers 1 bestrichene Fläche abdeckt.

Aus der Fig. 3 ist ferner ersichtlich, daß die Übernahmefläche 28 bezüglich der Brechungsflächen 31 einen relativ großen Überdeckungsgrad aufweist, so daß die infolge der unterschiedlichen Brechungswinkel der Brechungsflächen 31 unvermeidlichen Helligkeitsunterschiede so weit ausgleichbar sind, daß sie an der Zeigerfahne nicht mehr wahrgenommen werden können. Die durch die Erfindung erzielbare, hohe Lichtausbeute läßt es andererseits aber auch zu, daß dieser Mangel der auf maximale Lichtausbeute ausgelegten Konstruktion gemäß den Fig. 3 und 4 durch Variieren der Brechungsflächen und evtl. Vorsehen lichtstreuender Ausbildungen vor den der Lichtquelle am nächsten liegenden Brechungsflächen auf einfache Weise behoben werden kann. Denkbar ist aber auch, die hinsichtlich einer maximalen Lichtausbeute weniger günstig geneigten Brechungsflächen 31 in geeigneter Weise gewölbt, vorzugsweise jedoch in sich gestuft auszubilden, um auf diese Weise das zugeführte Licht möglichst verlustfrei im Bewegungsbereich der Übernahmefläche 28 zu konzentrieren und somit Helligkeitsunterschiede abzubauen.

Das Ausführungsbeispiel Fig. 5 zeigt für Fälle, in denen ein dickerer Lichtleitkörper 32 Anwendung finden und die Durchführöffnung 33 für die Zeigerwelle 16 relativ klein gehalten werden kann, oder ohnehin der Zeigerausschlag kleiner ist als 360°, daß eine praktisch geschlossene, lichtabstrahlende Ringfläche auch mit einer Lichtquelle erzielbar ist, indem die Umlenkfläche, z. B. 34 und 35, zweier Brechungsflächenscharen 36 und 37 gleichgerichtet und sozusagen in zwei Etagen des Lichtleitkörpers 32 ausgeformt werden.

## Patentanspruch

Anordnung zur Beleuchtung eines Zeigers (1) mittels Durchlicht mit wenigstens einer im Innern des betreffenden Meßgerätes angeordneten Lichtquelle (18, 19) und einem der Lichtquelle zugeordneten, plattenförmigen Lichtleitkörper (8), welcher in Zuordnung zur Zeigernabe derart ausgebildet ist, daß in den Lichtleitkörper (8) eingespeistes Licht an einer zur Zeigerwelle konzentrischen Fläche aus dem Lichtleitkörper austritt, dadurch gekennzeichnet, daß an dem Lichtleitkörper (8) wenigstens eine Schar (29) im wesentlichen ebener, lichtbrechender Flächen (31) ausgeformt ist, und zwar derart, daß einerseits die Brechungsflächen (31) bezüglich einer Ebene, in der sowohl die Lichtquelle (19) als auch die geometrische Achse der Zeigerwelle (16) liegen, senkrecht stehen, andererseits bezüglich der Zeigerwelle (16) geneigt und zueinander derart gestaffelt sind, daß die Projektion der Brechungsflächenschar (20) in Richtung der Zeigerwelle (16) eine im wesentlichen kreisbogenförmige Lichtaustrittsfläche ergibt.

## Claim

Arrangement for lighting an indicator (1) by transmitted light by means of at least one in the interior of the corresponding measuring device arranged light source (18, 19) and a plate-shaped light-guiding part (8) attributed to the indicator hub, which part is of such shape that light introduced into the light guide part (8) leaves the light guide part at a plane concentrical to the indicator shaft, characterized in that at the light guide part (8) there is at least a number (29) of essentially flat light reflecting planes (31) of such shape that on the one hand the reflection planes (31) are vertical with respect to a plane in which there are the light source (19) as well as the geometrical axle of the indicator shaft (18) and that on the other hand with respect to the indicator shaft (16) they are inclined and arranged staggered to each other so that the projection of the number of reflection planes (20) in the direction of the indicator shaft (16) results in an essentially circular shaped light transmitting plane.

### Revendication

Dispositif pour l'éclairage d'un indicateur (1) par transparence avec au moins une source lumineuse (18, 19) disposée à l'intérieur de l'appareil de mesure concerné et un corps conducteur de lumière (8) en forme de plaque associé à ladite source lumineuse lequel, en association avec le moyeu de l'indicateur, est réalisé de telle sorte que la lumière injectée dans le corps conducteur de lumière (8) émerge à une surface, concentrique par rapport à l'arbre d'indicateur, du corps conducteur de lumière, caractérisé par le fait que sur le corps conducteur de lumière (8) est formé au moins un groupe (29) de surfaces réfringentes (31) pour l'essentiel planes, et cela de telle sorte que, d'une part, les surfaces réfringentes (31) soient perpendiculaires par rapport à un plan dans lequel sont situés aussi bien la source lumineuse (19) que l'axe géométrique de l'arbre d'indicateur (16) et qu'elles soient, d'autre part, inclinées par rapport à l'arbre d'indicateur (16) et échelonnées les unes par rapport aux autres de telle sorte que la projection du groupe de surfaces réfringentes (20) en direction de l'arbre d'indicateur (16) donne une surface d'émergence de lumière, pour l'essentiel, en arc de cercle.

FIG. 1

FIG. 2

FIG. 3

FIG. 4

FIG. 5

3